# EUROPEAN PATENT APPLICATION

(11) **EP 4 407 682 A1**
(43) Date of publication of application: **31.07.2024**
(21) Application number: 24151575.8
(22) Date of filing: 12.01.2024
(51) Int. Cl.: H01L 27/02, G06F 30/392, H01L 27/118

(54) **INTEGRATED CIRCUIT INCLUDING STANDARD CELLS AND METHOD OF DESIGNING THE SAME**

(30) Priority: 16.01.2023 KR 20230006325; 27.01.2023 KR 20230011224; 18.04.2023 KR 20230050897
(71) Applicant: Samsung Electronics Co., Ltd., Suwon-si, Gyeonggi-do 16677 (KR)
(72) Inventor: CHO, Yongeun, 16677 Suwon-si, Gyeonggi-do (KR); CHOI, Eunhee, 16677 Suwon-si, Gyeonggi-do (KR); KIM, Kibum, 16677 Suwon-si, Gyeonggi-do (KR); KIM, Seonkyeong, 16677 Suwon-si, Gyeonggi-do (KR); KIM, Hayoung, 16677 Suwon-si, Gyeonggi-do (KR); ROH, Hyunjeong, 16677 Suwon-si, Gyeonggi-do (KR); BAE, Moogyu, 16677 Suwon-si, Gyeonggi-do (KR)
(74) Representative: Kuhnen & Wacker Patent- und Rechtsanwaltsbüro PartG mbB

(57) **Abstract**

An integrated circuit includes a first region having a plurality of first cells arranged in first rows extending in a first direction and a plurality of first gate electrodes extending in a second direction that crosses the first direction, a second region having a plurality of second cells arranged in second rows extending in the first direction and a plurality of second gate electrodes extending in the second direction, and a third region between the first region and the second region and having a plurality of third gate electrodes extending in the second direction. A second height of each of the second rows is greater than a first height of each of the first rows. A pitch of the first gate electrodes, a pitch of the second gate electrodes, and a pitch of the third gate electrodes are the same.

## Description

### CROSS-REFERENCE TO RELATED APPLICATIONS

This application is based on and claims priority under 35 U.S.C. § 119 to Korean Patent Application No. 10-2023-0006325, filed on January 16, 2023, Korean Patent Application No. 10-2023-0011224, filed on January 27, 2023, and Korean Patent Application No. 10-2023-0050897, filed on April 18, 2023, in the Korean Intellectual Property Office, the disclosures of which are incorporated by reference herein in their entireties.

### BACKGROUND

The present disclosure relates to an integrated circuit (IC), and more particularly, to an IC including standard cells and a method of designing the IC.

With the development of semiconductor processes, ICs may have a high integration density and may be required to have high performance. For example, smaller devices such as transistors may reduce the area of an IC and larger devices may efficiently increase the operating speed of an IC. Accordingly, to achieve the required functions and operating speed of an IC, it may be advantageous to optimally design an IC considering both integration density and performance.

### SUMMARY

Example embodiments provide an integrated circuit providing optimal integration density and performance and a method of designing the same.

According to an aspect of the disclosure, an integrated circuit includes: a first region including: a plurality of first cells arranged in first rows extending in a first direction; and a plurality of first gate electrodes extending in a second direction that crosses the first direction; a second region including: a plurality of second cells arranged in second rows extending in the first direction; and a plurality of second gate electrodes extending in the second direction; and a third region between the first region and the second region, the third region including a plurality of third gate electrodes extending in the second direction, wherein a second height of each of the second rows is greater than a first height of each of the first rows, and a pitch of the plurality of first gate electrodes, a pitch of the plurality of second gate electrodes, and a pitch of the plurality of third gate electrodes are the same.

According to an aspect of the disclosure, an integrated circuit includes: a first region including: a plurality of first cells arranged in first rows extending in a first direction; and a plurality of first gate electrodes extending in a second direction that crosses the first direction; a second region including: a plurality of second cells arranged in second rows extending in the first direction; and a plurality of second gate electrodes extending in the second direction; and a third region between the first region and the second region, wherein the third region includes a plurality of third gate electrodes extending in the second direction, a second height of each of the second rows is greater than a first height of each of the first rows, the plurality of second gate electrodes are aligned in the second direction with the plurality of first gate electrodes, and the plurality of third gate electrodes are aligned in the second direction with the plurality of first gate electrodes.

According to an aspect of the disclosure, an integrated circuit includes: a first region including a plurality of first cells arranged in first rows extending in a first direction; a second region including a plurality of second cells arranged in second rows extending in the first direction; and a third region surrounding the second region and surrounded by the first region, wherein a second height of each of the second rows is greater than a first height of each of the first rows, the third region has a length corresponding to a multiple of the first height in a second direction, the second direction crossing the first direction, and the second region has a length in the second direction corresponding to a multiple of a least common multiple of the first height and the second height.

### BRIEF DESCRIPTION OF THE DRAWINGS

The above and other aspects and features will be more apparent from the following detailed description of example embodiments taken in conjunction with the accompanying drawings, in which:
FIG. 1 is a diagram illustrating examples of cells according to one or more example embodiments;
FIG. 2 is a graph showing the relationship between the performance and the area of an integrated circuit (IC), according to one or more example embodiments;
FIGS. 3A, 3B, 3C and 3D are diagrams illustrating examples of devices according to example embodiments;
FIG. 4 is a diagram illustrating a mixed block according to one or more example embodiments;
FIGS. 5A and 5B are diagrams illustrating layouts of ICs according to example embodiments;
FIG. 6 is a diagram illustrating a layout of an IC according to one or more example embodiments;
FIG. 7 is a diagram illustrating a layout of an IC according to one or more example embodiments;
FIG. 8 is a diagram illustrating a layout of an IC according to one or more example embodiments;
FIGS. 9A and 9B are diagrams illustrating layouts of ICs according to one or more example embodiments;
FIGS. 10A, 10B and 10C are diagrams illustrating layouts of ICs according to example embodiments;
FIG. 11 is a diagram illustrating a layout of an IC according to one or more example embodiments;
FIG. 12 is a flowchart of a method of manufacturing an IC, according to one or more example embodiments;
FIG. 13 is a flowchart of a method of designing an IC, according to one or more example embodiments;
FIG. 14 is a block diagram of a system-on-chip (SoC) according to one or more example embodiments; and
FIG. 15 is a block diagram of a computing system including memory storing a program, according to one or more example embodiments.

### DETAILED DESCRIPTION

Hereinafter, example embodiments will be described in detail with reference to the accompanying drawings. The same reference numerals are used for the same components in the drawings, and duplicate descriptions thereof are omitted.

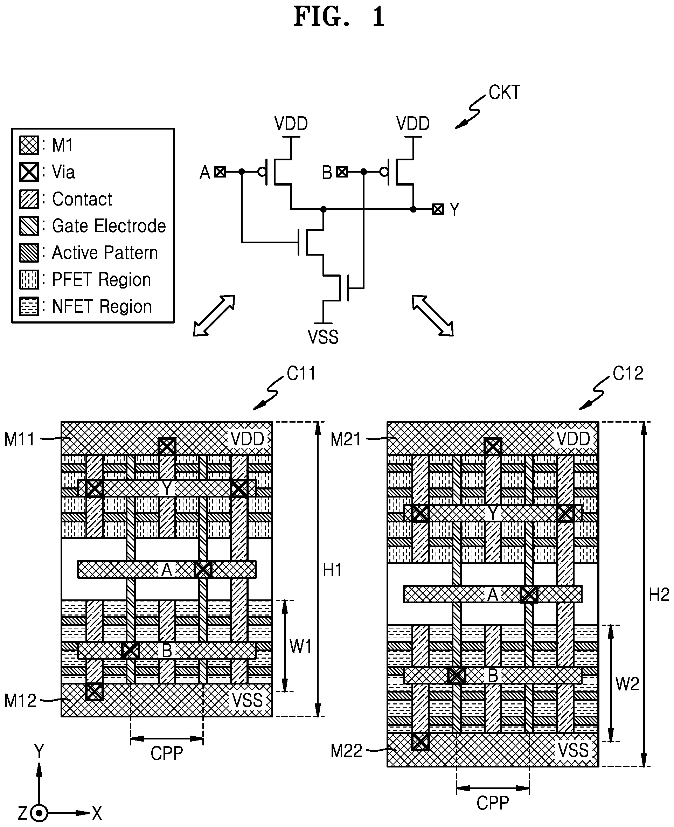

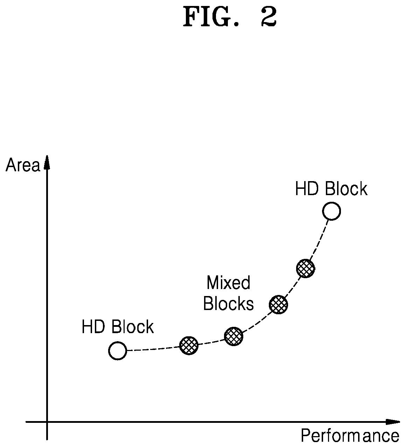

FIG. 1 is a diagram illustrating examples of cells according to one or more example embodiments. FIG. 2 is a graph showing the relationship between the performance and the area of an integrated circuit (IC), according to one or more example embodiments.

Herein, an X-axis direction and a Y-axis direction may be respectively referred to as a first direction and a second direction, and a Z-axis direction may be referred to as a vertical direction. A plane defined by an X-axis and a Y-axis may be referred to as a horizontal plane. An element positioned in a +Z direction relative to another element may be considered as being above the other element. An element positioned in a -Z direction relative to another element may be considered as being below the other element. The area of an element may refer to a size occupied by the element in a plane parallel with the horizontal plane, and the width of the element may refer to a length of the element in a direction perpendicular to the direction in which the element extends. A surface exposed in the +Z direction may be referred to as a top surface, a surface exposed in the -Z direction may be referred to as a bottom surface, and a surface exposed in a ±X direction or a ±Y direction may be referred to as a side surface. A pattern, such as a pattern of a wiring layer, which is formed of a conductive material, may be referred to as a conductive pattern or simply a pattern.

In the accompanying drawings, only some layers may be illustrated for convenience, and a via may be illustrated even though the via is below a pattern of a wiring layer to show the connection between the pattern of the wiring layer and a lower pattern. For convenience of illustration, it is illustrated that gate electrodes continuously extend in the Y-axis direction, but each of the gate electrodes may be divided into at least two gate electrodes by, for example, a gate cut.

FIG. 1 illustrates a circuit CKT corresponding to a NAND gate having two inputs A and B and one output Y, a first cell C11, and a second cell C12. An IC may include a plurality of cells. A cell is a layout unit included in the IC and may be designed to perform a predefined function and may be referred to as a standard cell. The IC may include various cells which may be arranged in a plurality of rows. For example, as shown in FIG. 1, each of the first cell C11 and the second cell C12 may be provided in a row extending in the X-axis direction. In other words, the first cell C11 may be provided in a row having a first height H1 and the second cell C12 may be provided in a row having a second height H2. According to one or more example embodiments, the second height H2 may be greater than the first height H1 (i.e., H2>H1). According to one or more example embodiments, a cell, such as the first cell C11 or the second cell C12, which is provided in a single row, may be referred to as a single-height cell. A cell continuously provided across at least two adjacent rows may be referred to as a multi-height cell.

A pattern, to which a positive supply voltage VDD is applied, and a pattern, to which a negative supply voltage VSS (or ground potential) is applied, may extend in the X-axis direction respectively at the boundaries of a row and may be referred to as power lines. For example, as shown in FIG. 1, patterns M11, M12, M21, and M22 of a first wiring layer M1, which is a lowest wiring layer, may extend in the X-axis direction. Herein, power lines and vias connecting the power lines to one another may be collectively referred to as a power rail. The first cell C11 and the second cell C12 may be supplied with power from the power rail.

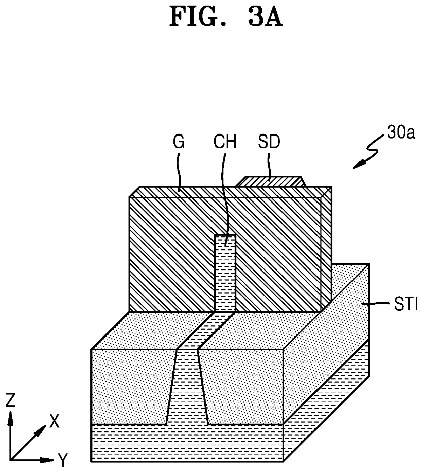

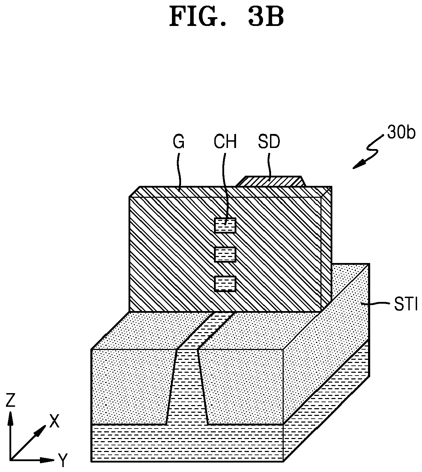

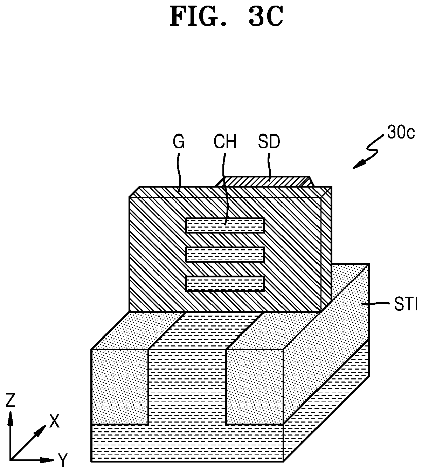

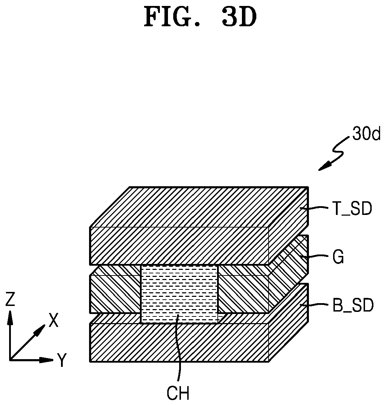

Device regions in which transistors are provided may extend in the X-axis direction. For example, as shown in FIG. 1, a p-channel field-effect transistor (PFET) region in which a PFET is provided and an n-channel FET (NFET) region in which an NFET is provided may extend in the X-axis direction in each of the first cell C11 and the second cell C12. At least one active pattern may extend in the X-axis direction in a device region. The at least one active pattern and a gate electrode may form a transistor which may extend in the Y-axis direction. Herein, a device region in which active patterns extend may be referred to as an active region. For example, as shown in FIG. 1, active patterns may extend in the X-axis direction in the PFET region and the NFET region. Examples of a transistor formed by using an active pattern and a gate electrode are described below with reference to FIGS. 3A, 3B, 3C and 3D.

The circuit CKT may include two NFETs and two PFETs. The first cell C11 and the second cell C12 may have the same function, i.e., a function a NAND gate, and may have different performances, e.g., different driving strengths and operating speeds. For example, the second cell C12 may have the second height H2 that is greater than the first height H1 (H2>H1) and have an NFET region having a second width W2 that is greater than a first width W1 of an NFET region of the first cell C11. Accordingly, the second cell C12 may include four active patterns extending in the X-axis direction in the NFET region thereof and the first cell C11 may include three active patterns extending in the X-axis direction in the NFET region thereof. In one or more example embodiments, when the first cell C11 and the second cell C12 include a multi-bridge channel FET (MBCFET) described below with reference to FIG. 3C, the width (i.e., the length in the Y-axis direction) of an active pattern extending in the NFET region of the second cell C12 may be greater than the width (i.e., the length in the Y-axis direction) of an active pattern extending in the NFET region of the first cell C11. Accordingly, NFETs of the second cell C12 may have a wider area than NFETs of the first cell C11 and may have higher driving strength and operating speed than the NFETs of the first cell C11. Herein, a cell, such as the first cell C11, which has a relatively small area, may be referred to as a high-density (HD) cell. A region or a block in which HD cells are provided may be referred to as an HD region or an HD block. A cell, such as the second cell C12, which provides relatively high performance, may be referred to as a high-performance (HP) cell. A region or a block in which HP cells are provided may be referred to as an HP region or an HP block.

Referring to FIG. 2, an HD block including only HD cells may have a smaller area and provide a lowest performance and an HP block including only HP cells may have a larger area and provide a higher performance. An IC may have requirements including higher performance than an HD block and a smaller area than an HP block, and accordingly, mixed blocks may be used as shown in FIG. 2. In other words, mixed blocks may include an HD region in which HD cells are provided and an HP region in which HP cells are provided and, thus, may provide the performance and area corresponding to the requirements of an IC.

In a mixed block, an HD region (herein, may be referred to as a first region) and an HP region (herein, may be referred to as a second region) may have different structures, respectively, and thus, it may be advantageous to efficiently interface an HD column and an HP column. For example, like the first cell C11 and the second cell C12, an HD region may have a different structure than an HP region due to different heights of rows. Accordingly, an interface region (herein, may be referred to as a third region) may be provided between an HD region and an HP region and may include a structure for interfacing between the HD region and the HP region. When the interface region has a large area, the efficiency of a mixed block may decrease.

Referring back to FIG. 1, the first cell C11 in an HD region and the second cell C12 in an HP region may include gate electrodes extending in the Y-axis direction and having the same pitch CPP. As described below with reference to the accompanying drawings, according to one or more example embodiments, an interface region may have a structure for efficiently interfacing between an HD region and an HP region, which have the same pitch of gate electrodes, and thus, the efficiency of a mixed block may increase and an IC including the mixed block may have optimal performance and area. In addition, the mixed block may be easily designed, and thus, the time-to-market of ICs meeting requirements may be significantly shortened.

FIGS. 3A, 3B, 3C and 3D are diagrams illustrating examples of devices according to example embodiments. For example, FIG. 3A illustrates a fin FET (FinFET) 30a, FIG. 3B illustrates a gate-all-around FET (GAAFET) 30b, FIG. 3C illustrates an MBCFET 30c, and FIG. 3D illustrates a vertical FET (VFET) 30d. For convenience of illustration, one of three source/drain regions is omitted from FIGS. 3A, 3B, 3C and 3D, and FIG. 3D illustrates a cross-section of the VFET 30d taken along a plane which is parallel to a plane formed by the Y axis and the Z axis and which passes through a channel CH of the VFET 30d.

Referring to FIG. 3A, the FinFET 30a may include a fin-shaped active pattern extending in the X-axis direction between shallow trench isolations (STIs) and a gate electrode G extending in the Y-axis direction. A source/drain region SD may be at each of opposite sides of the gate electrode G, and thus, a source and a drain may be separated from each other in the X-axis direction. An insulating film may be between a channel CH and the gate electrode G. In one or more example embodiments, the FinFET 30a may include the gate electrode G and a plurality of active patterns separated from each other in the Y-axis direction.

Referring to FIG. 3B, the GAAFET 30b may include active patterns, i.e., nanowires, which are separated from each other in the Z-axis direction and extend in the X-axis direction, and a gate electrode G extending in the Y-axis direction. A source/drain region SD may be at each of opposite sides of the gate electrode G, and thus, a source and a drain may be separated from each other in the X-axis direction. An insulating film may be between a channel CH and the gate electrode G. The number of nanowires in the GAAFET 30b is not limited to that illustrated in FIG. 3B.

Referring to FIG. 3C, the MBCFET 30c may include active patterns, i.e., nanosheets, which are separated from each other in the Z-axis direction and extend in the X-axis direction, and a gate electrode G extending in the Y-axis direction. A source/drain region SD may be at each of opposite sides of the gate electrode G, and thus, a source and a drain may be separated from each other in the X-axis direction. An insulating film may be between a channel CH and the gate electrode G. The number of nanosheets in the MBCFET 30c is not limited to that illustrated in FIG. 3C.

Referring to FIG. 3D, the VFET 30d may include a top source/drain T_SD and a bottom source/drain B_SD, which are separated from each other by a channel CH in the Z-axis direction. The VFET 30d may further include a gate electrode G, which is between the top source/drain T_SD and the bottom source/drain B_SD and surrounds the channel CH. An insulating film may be between the channel CH and the gate electrode G.

Hereinafter, an IC including the FinFET 30a or the MBCFET 30c is mainly described, but devices included in an IC are not limited to those illustrated in FIGS. 3A, 3B, 3C and 3D. For example, an IC may include a ForkFET having a structure in which an n-type transistor and a p-type transistor are close to each other because nanosheets for the p-type transistor and nanosheets for the n-type transistor are separated from each other by a dielectric wall. An IC may include a bipolar junction transistor as well as an FET such as a complementary FET (CFET), a negative CFET (NCFET), or a carbon nanotube (CNT) FET.

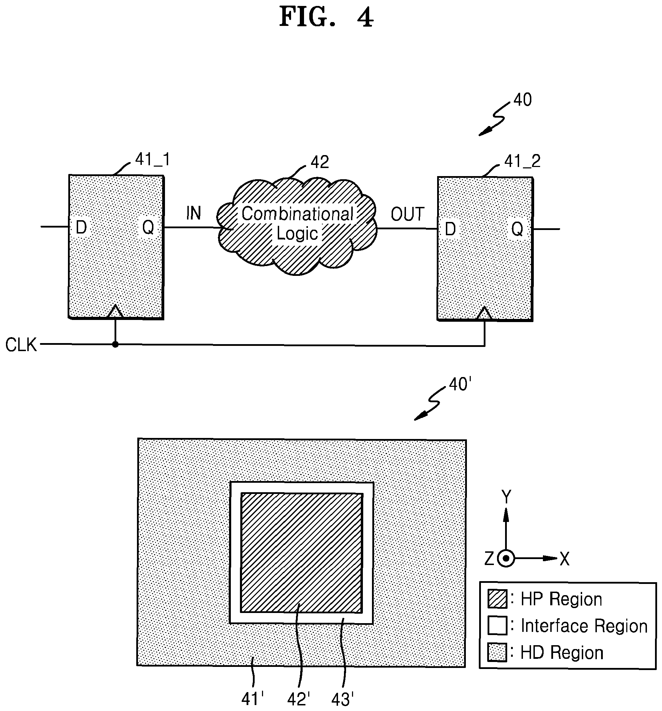

FIG. 4 is a diagram illustrating a mixed block according to one or more example embodiments. For example, FIG. 4 is a block diagram illustrating some elements of a mixed block 40 and shows a layout 40' of the mixed block 40.

Referring to FIG. 4, the mixed block 40 may include a first flip-flop 41_1, a second flip-flop 41_2, and a combinational logic 42. Each of the first flip-flop 41_1 and the second flip-flop 41_2 may generate an output Q from an input D, wherein the output Q is synchronized with a clock signal CLK. The combinational logic 42 may generate an output signal OUT from an input signal IN, which is received from the first flip-flop 41_1, and may provide the output signal OUT to the second flip-flop 41_2. The combinational logic 42 may include at least one logic gate. When the combinational logic 42 corresponds to a critical path, a propagation delay, i.e., the time taken for the output signal OUT to be generated from the input signal IN, may determine the frequency of the clock signal CLK. The operating speed of the mixed block 40 may depend on the frequency of the clock signal CLK.

While the first flip-flop 41_1 and the second flip-flop 41_2 may include HD cells, the combinational logic 42 may include HP cells to reduce the propagation delay. For example, as shown in FIG. 4, the layout 40' may include an HD region 41' and an HP region 42'. HD cells may be provided in the HD region 41' and HP cells may be provided in the HP region 42'. The layout 40' may further include an interface region 43' surrounding the HP region 42'. The HD region 41' may surround the interface region 43'. As described above with reference to FIG. 2, when the interface region 43' has a small area, the efficiency of the interface region 43' may increase.

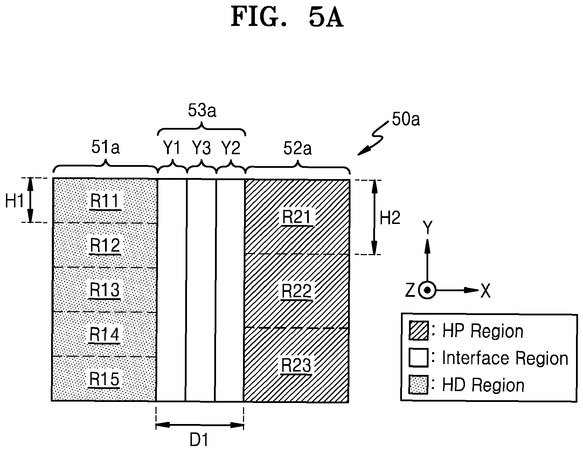

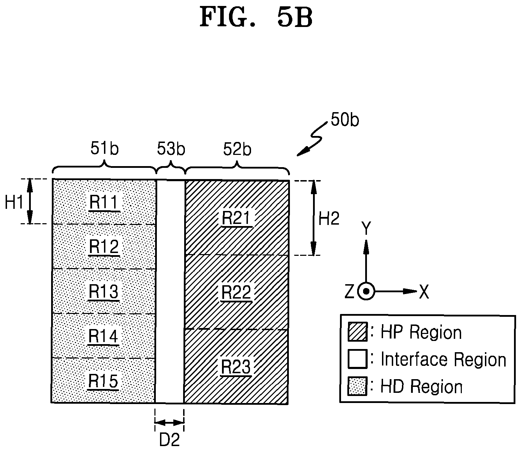

FIGS. 5A and 5B are diagrams illustrating layouts of ICs according to embodiments. For example, FIGS. 5A and 5B illustrate portions of an HD region, an interface region, and an HP region.

Referring to FIG. 5A, a layout 50a may include an HD region 5 1a, an HP region 52a, and an interface region 53a. In the HD region 51a, first to fifth rows R11, R12, R13, R14 and R15 may extend in the X-axis direction. Each of the first to fifth rows R11, R12, R13, R14 and R15 may have a first height H1. In the HP region 52a, first to third rows R21, R22 and R23 may extend in the X-axis direction. Each of the first to third rows R21, R22 and R23 may have a second height H2 that is greater than the first height H1.

The interface region 53a may include first to third portions Y1, Y2 and Y3. Finishing cells for the HD region 51a may be arranged in the first portion Y1 and finishing cells for the HP region 52a may be arranged in the second portion Y2. The third portion Y3 may correspond to a space for preventing interference between the finishing cells of the first portion Y1 and the finishing cells of the second portion Y2. Accordingly, the interface region 53a may have a first length D1 in the X-axis direction, wherein the first length D1 is greater than a second length D2 described below with reference to FIG. 5B (i.e., D1>D2).

Referring to FIG. 5B, a layout 50b may include an HD region 5 1b, an HP region 52b, and an interface region 53b. In the HD region 51b, the first to fifth rows R11, R12, R13, R14 and R15 may extend in the X-axis direction. Each of the first to fifth rows R11, R12, R13, R14 and R15 may have a first height H1. In the HP region 52b, the first to third rows R21, R22 and R23 may extend in the X-axis direction. Each of the first to third rows R21, R22 and R23 may have a second height H2 that is greater than the first height H1.

The interface region 53b may have a second length D2 in the X-axis direction, which is less than the first length D1 described above with reference to FIG. 5A. For example, the interface region 53b may include a transition structure between the HD region 51b and the HP region 52b, instead of a structure that finishes each of the HD region 5 1b and the HP region 52b. Accordingly, the first portion Y1 and the second portion Y2 in FIG. 5A may be omitted from the interface region 53b and the third portion Y3 for the first portion Y1 and the second portion Y2 may also be omitted. Examples of the interface region 53b are described below with reference to the drawings.

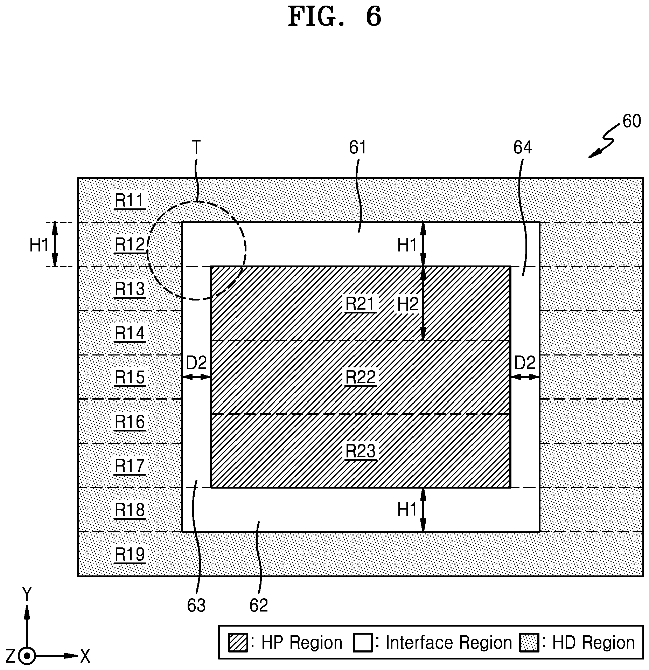

FIG. 6 is a diagram illustrating a layout 60 of an IC according to one or more example embodiments. For example, FIG. 6 illustrates the layout 60 including an HP region, an interface region surrounding the HP region, and an HD region surrounding the interface region. However, embodiments are not limited to the number of rows illustrated in FIG. 6.

Referring to FIG. 6, a series of rows R11, R12, R13, R14, R15, R16, R17, R18 and R19 may extend in the X-axis direction in the HD region. Each of the rows R11, R12, R13, R14, R15, R16, R17, R18 and R19 may have a first height H1. A series of rows R21, R22 and R23 may extend in the X-axis direction in the HP region. Each of the rows R21, R22 and R23 may have a second height H2. The interface region may include a first portion 61 and a second portion 62, which extend in the X-axis direction, and a third portion 63 and a fourth portion 64, which extend in the Y-axis direction.

In one or more example embodiments, the HP region may have a length in the Y-axis direction, which corresponds to a multiple of the least common multiple of the first height H1 and the second height H2. For example, the ratio of the first height H1 to the second height H2 in the example of FIG. 6 may be 2:3 and the HP region may have a length corresponding to the least common multiple of the first height H1 and the second height H2 in the Y-axis direction. In other words, each of the third portion 63 and the fourth portion 64 of the interface region may have a length corresponding to the least common multiple of the first height H1 and the second height H2 in the Y-axis direction. Accordingly, as shown in FIG. 6, the HP region may be aligned with rows in the HD region in the X-axis direction.

In one or more example embodiments, the HP region may be separated from the HD region in the Y-axis direction by a multiple of the first height H1. For example, as shown in FIG. 6, the HP region may be separated from the HD region in the Y-axis direction by the first height H1. In other words, each of the first portion 61 and the second portion 62 of the interface region may have a length in the Y-axis direction, which corresponds to the first height H1. As described with reference to FIG. 5B, the HP region may be separated from the HD region in the X-axis direction by the second length D2. In other words, each of the third portion 63 and the fourth portion 64 of the interface region may have a second length D2 in the X-axis direction. Examples of a region T marked with a dashed-line circle in FIG. 6 are described below with reference to the drawings.

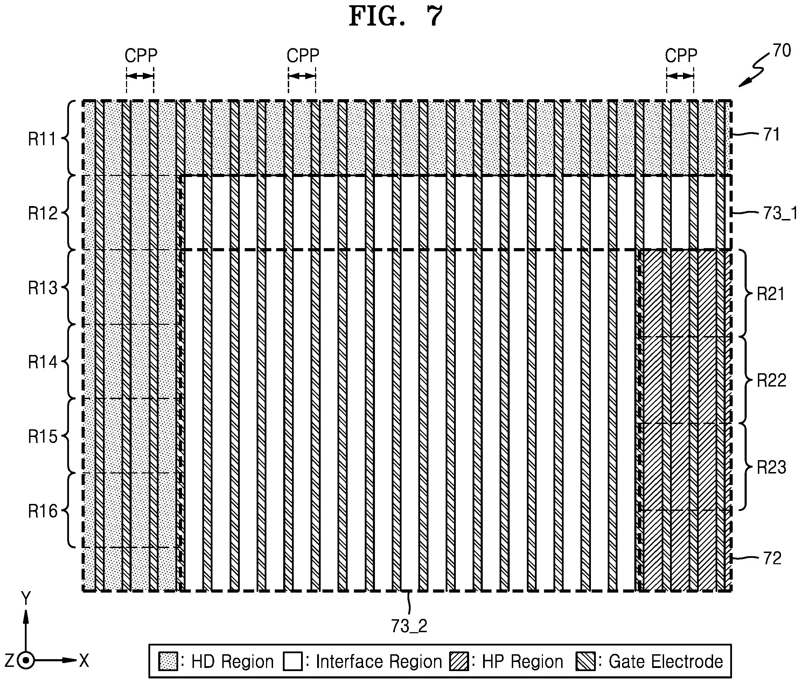

FIG. 7 is a diagram illustrating a layout 70 of an IC according to one or more example embodiments. As shown in FIG. 7, the layout 70 may include an HD region 71, an HP region 72, and an interface region between the HD region 71 and the HP region 72. The interface region may include a first portion 73_1 extending in the X-axis direction and a third portion 73_2 extending in the Y-axis direction. A series of rows R11, R12, R13, R14, R15 and R16 may extend in the X-axis direction in the HD region 71 and a series of rows R21, R22 and R23 may extend in the X-axis direction in the HP region 72.

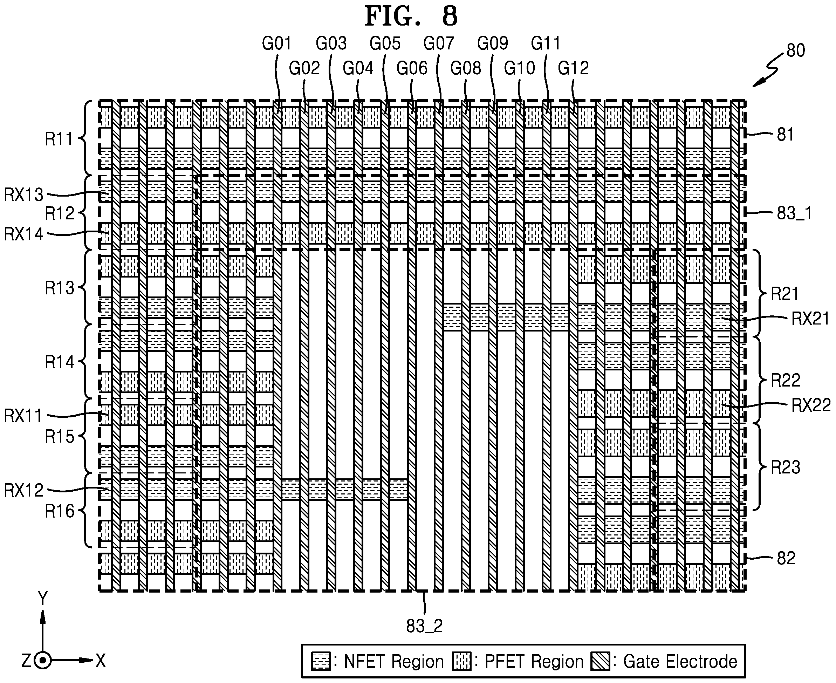

A plurality of gate electrodes (herein, may be referred to as a plurality of first gate electrodes) may extend in the Y-axis direction in the HD region 71. A plurality of gate electrodes (herein, may be referred to as a plurality of second gate electrodes) may extend in the Y-axis direction in the HP region 72. A plurality of gate electrodes (herein, may be referred to as a plurality of third gate electrodes) may extend in the Y-axis direction in the interface region between the HD region 71 and the HP region 72. As shown in FIG. 7, the first gate electrodes, the second gate electrodes, and the third gate electrodes may have the same pitch CPP. Examples of a layout including an HD region, an HP region, and an interface region, which are respectively analogous to the HD region 71, the HP region 72, and the interface region in FIG. 7, are described below with reference to FIGS. 8, 9, 10 and 11.

FIG. 8 is a diagram illustrating a layout 80 of an IC according to one or more example embodiments. For example, FIG. 8 illustrates PFET regions and NFET regions, which extend in the X-axis direction, and gate electrodes, which extend in the Y-axis direction in the layout 80. An active pattern extends in the X-axis direction in each of the PFET region and the NFET region and has the same length as the PFET region or the NFET region. As described above with reference to FIG. 1, the PFET region or the NFET region in an HP region may have a larger width than the PFET region or the NFET region in an HD region.

Referring to FIG. 8, the layout 80 may include an HD region 81, an HP region 82, and an interface region between the HD region 81 and the HP region 82. The interface region may include a first portion 83_1 extending in the X-axis direction and a third portion 83_2 extending in the Y-axis direction. A series of rows R11, R12, R13, R14, R15 and R16 may extend in the X-axis direction in the HD region 81 and a series of rows R21, R22 and R23 may extend in the X-axis direction in the HP region 82.

A plurality of active patterns may extend in the X-axis direction across the boundary between the HD region 81 and the interface region and may terminate in the interface region. For example, PFET regions and NFET regions in the rows R13, R14, R15 and R16 of the HD region 81 may extend in the X-axis direction across the boundary between the HD region 81 and the third portion 83_2 of the interface region and may terminate in the third portion 83_2 of the interface region. A plurality of active patterns may extend in the X-axis direction across the boundary between the HP region 82 and the interface region. For example, PFET regions and NFET regions in the rows R21, R22 and R23 of the HP region 82 may extend in the X-axis direction across the boundary between the HP region 82 and the third portion 83_2 of the interface region and may terminate in the third portion 83_2 of the interface region. At least one active pattern in each of the PFET regions and the NFET regions may extend in the X-axis direction.

In one or more example embodiments, active patterns may respectively have different lengths in the X-axis direction in the interface region. For example, a PFET region RX11 in the row R15 of the HD region 81 may extend to a first gate electrode G01 in the X-axis direction and an NFET region RX12 in the row R16 of the HD region 81 may extend to a sixth gate electrode G06 in the X-axis direction. When the length of a gate electrode that does not cross an active pattern is at least a reference value, the gate electrode may not be easily provided by semiconductor processes. Accordingly, the length of a gate electrode that does not cross an active pattern may be limited. As shown in FIG. 8, the NFET region RX12 or at least one active pattern in the NFET region RX12 may extend to the sixth gate electrode G06 in the X-axis direction, and, accordingly, second, third, fourth, fifth and sixth gate electrodes G02, G03, G04, G05 and G06 may be easily provided by semiconductor processes. Similarly, a PFET region RX22 in the row R22 of the HP region 82 may extend to a twelfth gate electrode G12 in the X-axis direction and an NFET region RX21 in the row R21 of the HP region 82 may extend to a seventh gate electrode G07 in the X-axis direction. Accordingly, seventh, eighth, ninth, tenth, eleventh and twelfth gate electrodes G07, G08, G09, G10, G11 and G12 may be easily provided by semiconductor processes.

In one or more example embodiments, active patterns may extend in the X-axis direction from a portion of the HD region 81 to another portion of the HD region 81 across the interface region. For example, an NFET region RX13 and a PFET region RX14 in the row R12 of the HD region 81 may extend in the X-axis direction across the first portion 83_1 of the interface region.

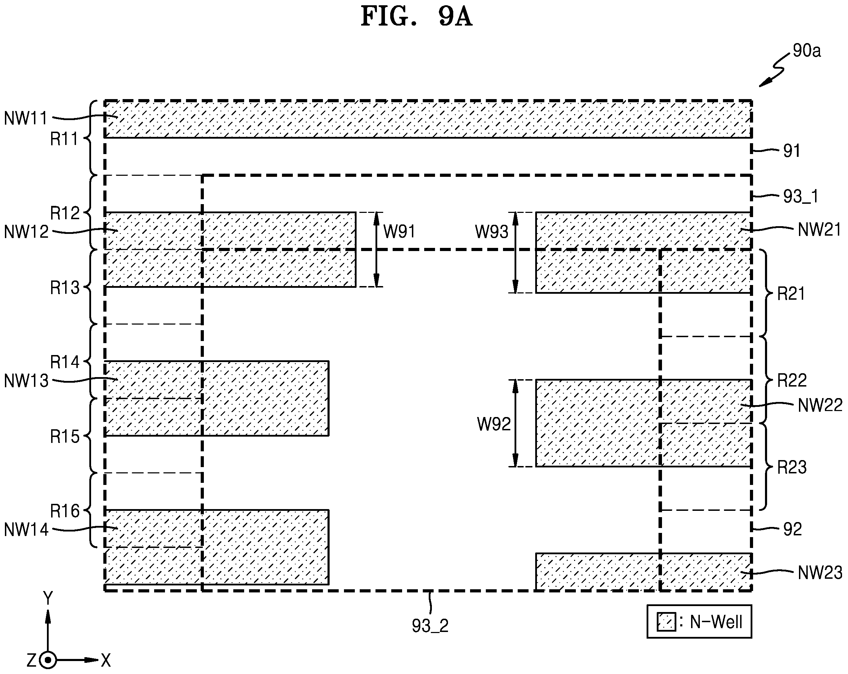

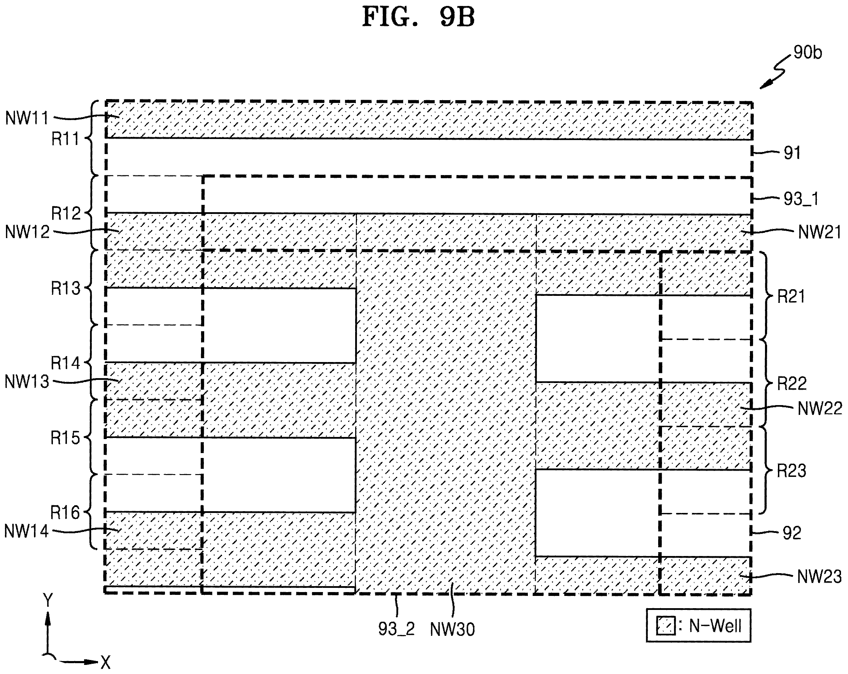

FIGS. 9A and 9B are diagrams illustrating layouts of ICs according to one or more example embodiments. For example, FIGS. 9A and 9B illustrate n-wells in layouts 90a and 90b. PFET regions may extend in the X-axis direction in n-wells and PFETs may be provided of gate electrodes extending in the Y-axis direction.

As shown in FIGS. 9A and 9B, each of the layouts 90a and 90b may include an HD region 91, an HP region 92, and an interface region between the HD region 91 and the HP region 92. The interface region may include a first portion 93_1 extending in the X-axis direction and a third portion 93_2 extending in the Y-axis direction. A series of rows R11, R12, R13, R14, R15 and R16 may extend in the X-axis direction in the HD region 91 and a series of rows R21, R22 and R23 may extend in the X-axis direction in the HP region 92.

Referring to FIG. 9A, a plurality of wells may extend in the X-axis direction across the boundary between the HD region 91 and the interface region and may terminate in the interface region. For example, n-wells NW12, NW13 and NW14 may extend in the X-axis direction across the boundary between the HD region 91 and the interface region and may terminate in the interface region. An n-well NW11 may extend in the X-axis direction in the HD region 91. A plurality of wells may extend in the X-axis direction across the boundary between the HP region 92 and the interface region and may terminate in the interface region. For example, n-wells NW22 and NW23 may extend in the X-axis direction across the boundary between the HP region 92 and the interface region and may terminate in the interface region. An n-well NW21 may extend in the X-axis direction along the boundary between the HP region 92 and the interface region and may terminate in the interface region. In one or more example embodiments, wells may respectively have different lengths in the X-axis direction in the interface region. For example, the n-well NW12 may be longer in the X-axis direction than each of the n-wells NW13 and NW14 in the interface region.

The width of a well extending in an HP region may be greater than that of a well extending in an HD region. For example, a width W92 of the n-well NW22 may be greater than a width W91 of the n-well NW12 (i.e., W92>W91). In one or more example embodiments, a width W93 of the n-well NW21 extending in the X-axis direction along the boundary between the HP region 92 and the interface region may be greater than the width W91 of the n-well NW12 and less than the width W92 of the n-well NW22 (i.e., W91<W93<W92). In one or more example embodiments, the width W93 of the n-well NW21 may be half the sum of the width W91 of the n-well NW12 and the width W92 of the n-well NW22 (i.e., W93=W91/2+W92/2).

Referring to FIG. 9B, a plurality of wells may extend in the X-axis direction across the boundary between the HD region 91 and the interface region. For example, the n-wells NW12, NW13 and NW14 in the HD region 91 may extend in the X-axis direction across the boundary between the HD region 91 and the interface region. The n-well NW11 may extend in the X-axis direction in the HD region 91. A plurality of wells may extend in the X-axis direction across the boundary between the HP region 92 and the interface region. For example, the n-wells NW22 and NW23 in the HP region 92 may extend in the X-axis direction across the boundary between the HP region 92 and the interface region and may terminate in the interface region.

In one or more example embodiments, HD cells in the HD region 91 and HP cells in the HP region 92 may have the same power domain. For example, HD cells and HP cells may have the same positive supply voltage VDD and the same negative supply voltage VSS. Accordingly, a biasing voltage (e.g., VDD) of an n-well extending in the HD region 91 may be the same as a biasing voltage (e.g., VDD) of an n-well extending in the HP region 92. In one or more example embodiments, n-wells extending from the HD region 91 and n-wells extending from the HP region 92 may be connected to each other in the interface region. For example, an n-well NW30 may extend in the Y-axis direction in the interface region and connect the n-wells NW12, NW13 and NW14 extending from the HD region 91 to the n-wells NW21, NW22 and NW23 extending from the HP region 92.

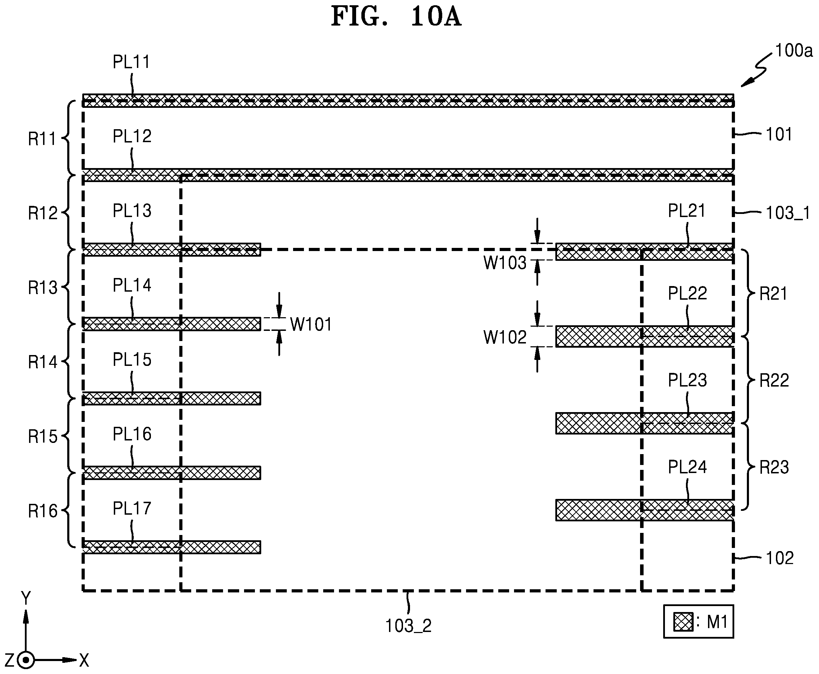

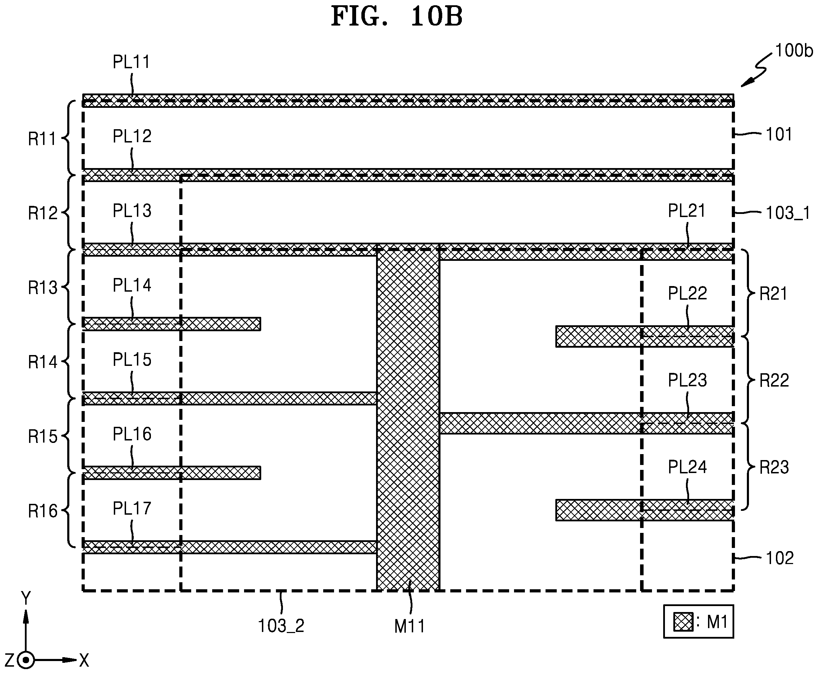

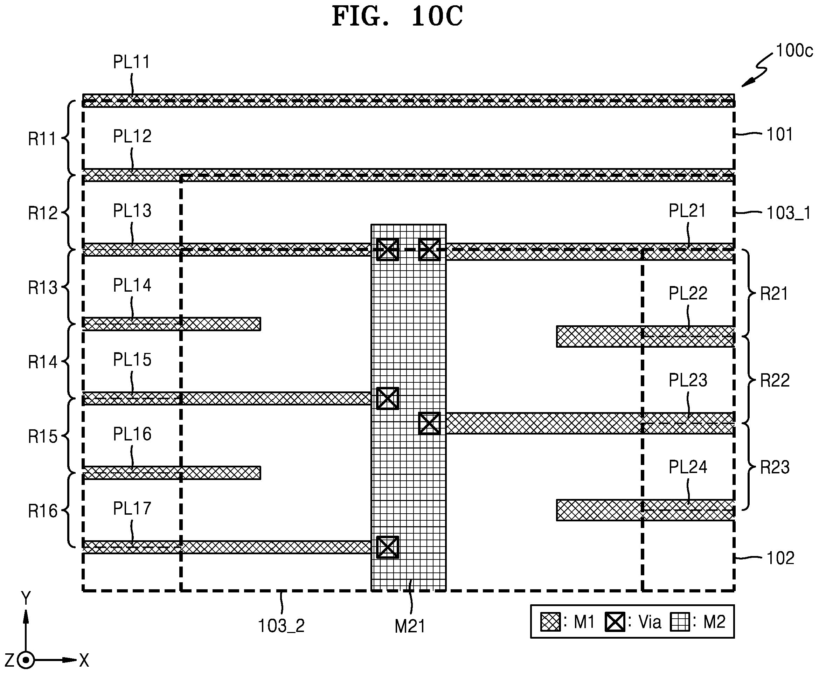

FIGS. 10A, 10B and 10C are diagrams illustrating layouts of ICs according to one or more example embodiments. For example, FIGS. 10A, 10B and 10C illustrate power lines in layouts 100a, 100b, and 100c.

As shown in FIGS. 10A, 10B and 10C, each of the layouts 100a, 100b, and 100c may include an HD region 101, an HP region 102, and an interface region between the HD region 101 and the HP region 102. The interface region may include a first portion 103_1 extending in the X-axis direction and a third portion 103_2 extending in the Y-axis direction. A series of rows R11, R12, R13, R14, R15 and R16 may extend in the X-axis direction in the HD region 101 and a series of rows R21, R22 and R23 may extend in the X-axis direction in the HP region 102.

Referring to FIG. 10A, a plurality of power lines may extend in the X-axis direction across the boundary between the HD region 101 and the interface region and may terminate in the interface region. For example, power lines PL13, PL14, PL15, PL16 and PL17 may extend in the first wiring layer M1 in the X-axis direction across the boundary between the HD region 101 and the interface region and may terminate in the interface region. A plurality of power lines may extend in the X-axis direction across the boundary between the HP region 102 and the interface region and may terminate in the interface region. For example, power lines PL21, PL22, PL23 and PL24 may extend in the first wiring layer M1 in the X-axis direction across the boundary between the HP region 102 and the interface region and may terminate in the interface region. A power line PL11 may extend in the X-axis direction in the HD region 101 and a power line PL12 may include a portion extending in the X-axis direction along the boundary between the HD region 101 and the interface region. The power line PL21 may extend in the X-axis direction along the boundary between the HP region 102 and the interface region and may terminate in the interface region.

The width of a power line extending in an HP region may be greater than a width of a power line extending in an HD region. For example, a width W102 of the power line PL22 may be greater than a width W101 of the power line PL14 (i.e., W102>W101). A width W103 of the power line PL21 extending in the X-axis direction along the boundary between the HP region 102 and the interface region may be greater than the width W101 of the power line PL14 and less than the width W102 of the power line PL22 (i.e., W102>W103>W101). In one or more example embodiments, the width W103 of the power line PL23, which is less than the width W102 of the power line PL22, may be half the sum of the width W101 of the power line PL14 and the width W102 of the power line PL22 (i.e., W103=W101/2+W102/2).

Referring to FIG. 10B, a plurality of power lines may extend in the X-axis direction across the boundary between the HD region 101 and the interface region. For example, the power lines PL13, PL14, PL15, PL16 and PL17 may extend in the first wiring layer M1 in the X-axis direction across the boundary between the HD region 101 and the interface region. A plurality of power lines may extend in the X-axis direction across the boundary between the HP region 102 and the interface region. For example, the power lines PL21, PL22, PL23 and PL24 may extend in the first wiring layer M1 in the X-axis direction across the boundary between the HP region 102 and the interface region. The power line PL11 may extend in the X-axis direction in the HD region 101 and the power line PL12 may include a portion extending in the X-axis direction along the boundary between the HD region 101 and the interface region. The power line PL21 may extend in the X-axis direction along the boundary between the HP region 102 and the interface region.

In one or more example embodiments, HD cells in the HD region 101 and HP cells in the HP region 102 may have the same power domain. For example, HD cells and HP cells may have the same positive supply voltage VDD and the same negative supply voltage VSS. Accordingly, power lines, to which the positive supply voltage VDD is applied, may extend in the HD region 101 and the HP region 102. In one or more example embodiments, at least one power line extending from the HD region 101 and at least one power line extending from the HP region 102 may be connected to each other in the interface region. For example, a pattern M11 of the first wiring layer M1 may extend in the Y-axis direction in the interface region and may be connected to the power lines PL13, PL15, and PL17 extending from the HD region 101 and the power lines PL21 and PL23 extending from the HP region 102. In one or more example embodiments, the positive supply voltage VDD may be applied to the power lines PL13, PL15, PL17, PL21, and PL23.

Referring to one or more example embodiments shown in FIG. 10C, a plurality of power lines may extend in the X-axis direction across the boundary between the HD region 101 and the interface region. For example, the power lines PL13, PL14, PL15, PL16 and PL17 may extend in the first wiring layer M1 in the X-axis direction across the boundary between the HD region 101 and the interface region. A plurality of power lines may extend in the X-axis direction across the boundary between the HP region 102 and the interface region. For example, the power lines PL21, PL22, PL23 and PL24 may extend in the first wiring layer M1 in the X-axis direction across the boundary between the HP region 102 and the interface region. The power line PL11 may extend in the X-axis direction in the HD region 101 and the power line PL12 may include a portion extending in the X-axis direction along the boundary between the HD region 101 and the interface region. The power line PL21 may extend in the X-axis direction along the boundary between the HP region 102 and the interface region.

In one or more example embodiments, HD cells in the HD region 101 and HP cells in the HP region 102 may have the same power domain. For example, HD cells and HP cells may have the same positive supply voltage VDD and the same negative supply voltage VSS. Accordingly, power lines, to which the positive supply voltage VDD is applied, may extend in the HD region 101 and the HP region 102. In one or more example embodiments, at least one power line extending from the HD region 101 and at least one power line extending from the HP region 102 may be connected to each other in the interface region. For example, a pattern M21 of a second wiring layer M2 above the first wiring layer M1 may extend in the Y-axis direction in the interface region and may be connected through vias to the power lines PL13, PL15, and PL17 extending from the HD region 101 and the power lines PL21 and PL23 extending from the HP region 102. In one or more example embodiments, the positive supply voltage VDD may be applied to the power lines PL13, PL15, PL17, PL21, and PL23.

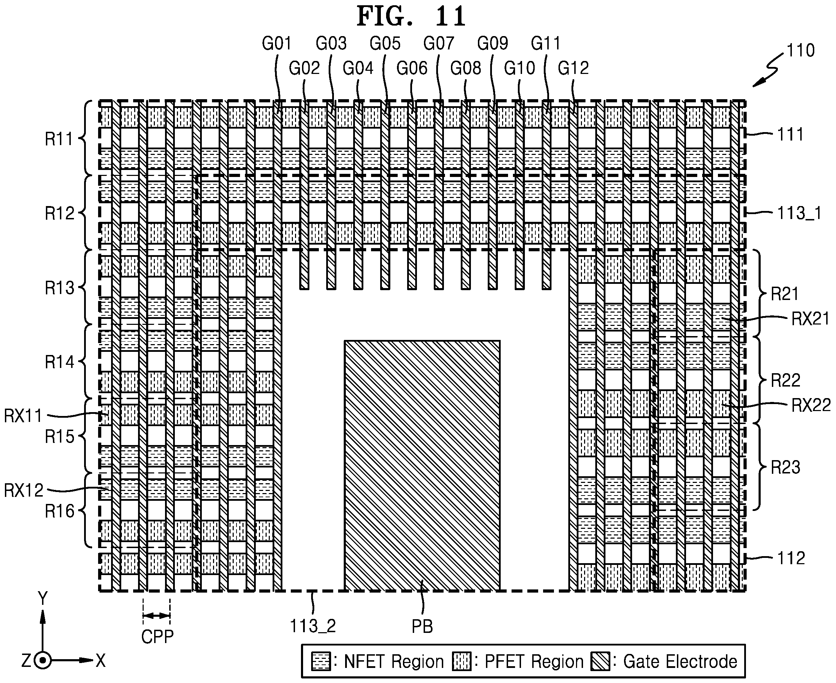

FIG. 11 is a diagram illustrating a layout 110 of an IC according to one or more example embodiments. For example, FIG. 11 illustrates PFET regions and NFET regions, which extend in the X-axis direction, and gate electrodes extending in the Y-axis direction in the layout 110. It is assumed that an active pattern extends in the X-axis direction in each of the PFET region and the NFET region and has the same length as the PFET region or the NFET region. As described above with reference to FIG. 1, the PFET region or the NFET region in an HP region may have a larger width than the PFET region or the NFET region in an HD region.

Referring to FIG. 11, the layout 110 may include an HD region 111, an HP region 112, and an interface region between the HD region 111 and the HP region 112. The interface region may include a first portion 113_1 extending in the X-axis direction and a third portion 113_2 extending in the Y-axis direction. A series of rows R11, R12, R13, R14, R15 and R16 may extend in the X-axis direction in the HD region 111 and a series of rows R21, R22 and R23 may extend in the X-axis direction in the HP region 112.

A plurality of active patterns may extend in the X-axis direction across the boundary between the HD region 111 and the interface region and may terminate in the interface region. For example, PFET regions and NFET regions in the rows R13, R14, R15 and R16 of the HD region 111 may extend in the X-axis direction across the boundary between the HD region 111 and the third portion 113_2 of the interface region and may terminate in the third portion 113_2 of the interface region. A plurality of active patterns may extend in the X-axis direction across the boundary between the HP region 112 and the interface region. For example, PFET regions and NFET regions in the rows R21, R22 and R23 of the HP region 112 may extend in the X-axis direction across the boundary between the HP region 112 and the third portion 113_2 of the interface region and may terminate in the third portion 113_2 of the interface region. At least one active pattern in each of the PFET regions and the NFET regions may extend in the X-axis direction.

A plurality of gate electrodes may extend in the X-axis direction across the boundary between the HD region 111 and the interface region and may terminate in the interface region. For example, the second, third, fourth, fifth, sixth, seventh, eighth, ninth, tenth and eleventh gate electrodes G02, G03, G04, G05, G06, G07, G08, G09, G10 and G11 may extend from the HD region 111 across the first portion 113_1 of the interface region and may terminate in the third portion 113_2 of the interface region.

In one or more example embodiments, a wide gate electrode may extend in the Y-axis direction in the interface region. For example, as shown in FIG. 11, a gate electrode PB may extend in the Y-axis direction in the third portion 113_2 of the interface region. The gate electrode PB may be close in the Y-axis direction to the second, third, fourth, fifth, sixth, seventh, eighth, ninth, tenth and eleventh gate electrodes G02, G03, G04, G05, G06, G07, G08, G09, G10 and G11 terminating in the interface region. In one or more example embodiments, the gate electrode PB may have a width, i.e., a length in the X-axis direction, which is greater than the pitch CPP of the other gate electrodes. In one or more example embodiments, the gate electrode PB may have a width where the proportion per unit area of a gate electrode is uniform in the layout 110. Herein, a gate electrode, such as the gate electrode PB, which is wider than gate electrodes forming a transistor, may be referred to as a wide gate electrode.

In one or more example embodiments, active patterns may have the same length in the X-axis direction in the interface region. For example, the PFET region RX11 and the NFET region RX12, which extend from the HD region 111, may extend to the first gate electrode G01 in the X-axis direction. The NFET region RX21 and the PFET region RX22, which extend from the HP region 112, may extend to the twelfth gate electrode G12 in the X-axis direction. In the layout 110 of FIG. 11 unlike the layout 80 of FIG. 8, the second, third, fourth, fifth, sixth, seventh, eighth, ninth, tenth and eleventh gate electrodes G02, G03, G04, G05, G06, G07, G08, G09, G10 and G11 may terminate in the interface region, and accordingly, an active pattern crossing the second, third, fourth, fifth, sixth, seventh, eighth, ninth, tenth and eleventh gate electrodes G02, G03, G04, G05, G06, G07, G08, G09, G10 and G11 may be omitted from the third portion 113_2 of the interface region.

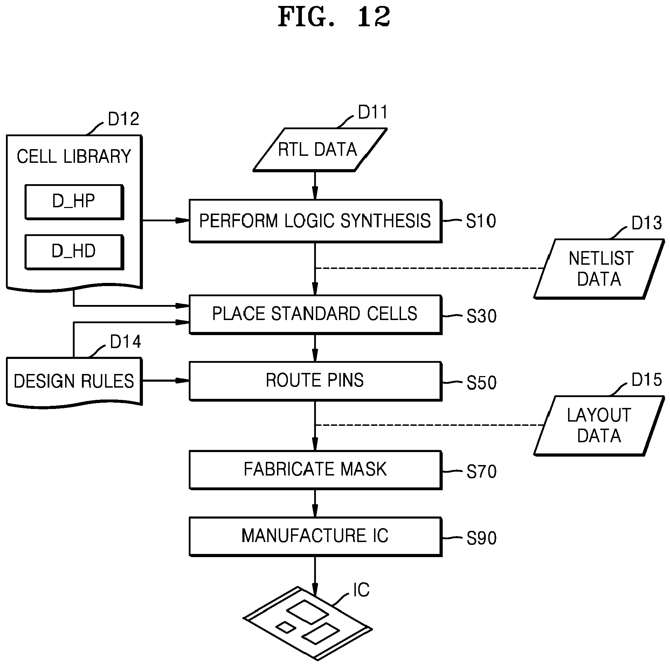

FIG. 12 is a flowchart of a method of manufacturing an IC, according to one or more example embodiments. For example, the flowchart of FIG. 12 is an example of a method of manufacturing an IC including standard cells. As shown in FIG. 12, the method of manufacturing an IC may include a plurality of operations S10, S30, S50, S70, and S90.

A cell library (or a standard cell library) D12 may include information about standard cells, e.g., information about functions, characteristics, layouts, or the like of standard cells. In one or more example embodiments, the cell library D12 may define a plurality of standard cells, which correspond to each of different layouts and may correspond to the same function. For example, as shown in FIG. 12, the cell library D12 may include data D_HP defining HP cells and data D_HD defining HD cells. In one or more example embodiments, the cell library D12 may define standard cells having various heights.

Design rules D14 may include requirements for the layout of an IC. For example, the design rules D14 may include requirements for the spacing between patterns in one layer, the minimum width of a pattern, the routing direction of a wiring layer, and the like. In one or more example embodiments, the design rules D14 may define a minimum spacing in a track of a wiring layer.

Logic synthesis, by which netlist data D13 is generated from RTL data D11, may be performed in operation S10. For example, a semiconductor design tool (e.g., a logic synthesis tool) may perform logic synthesis on the RTL data D11, which is written in very high speed IC (VHSIC) hardware description language (HDL) (VHDL) and HDL, such as, but not limited to, Verilog, with reference to the cell library D12, and may generate the netlist data D13 including bitstream data or netlist data. The netlist data D13 may correspond to the input of placement and routing, which is described below.

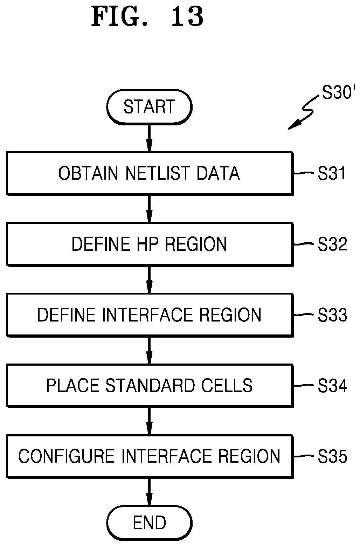

Cells may be placed in operation S30. For example, a semiconductor design tool (e.g., a place and route (P&R) tool) may place standard cells, which are used in the netlist data D13, with reference to the cell library D12. In one or more example embodiments, a semiconductor design tool may place HD cells in an HD region and HP cells in an HP region. An example of operation S30 is described below with reference to one or more example embodiments of FIG. 13.

The pins of the standard cells may be routed in operation S50. For example, a semiconductor design tool may generate interconnections that electrically connect the output and input pins of placed standard cells and may generate layout data D15 that defines the placed standard cells and the interconnections. An interconnection may include a via of a via layer and/or a pattern of a wiring layer. For example, the layout data D15 may have a format like graphic design system II (GDSII) and include geometrical information of cells and interconnections. A semiconductor design tool may refer to the design rules D14 while routing the pins of cells. The layout data D15 may correspond to the output of place and route (P&R). Operation S50 may be solely or operations S30 and S50 may be collectively referred to as a method of designing an IC. Herein, the layout data D15 may be referred to as output data.

A mask may be fabricated in operation S70. For example, optical proximity correction (OPC) for correcting distortion, such as refraction, caused by the characteristics of light in photolithography may be performed on the layout data D15. Patterns on a mask may be defined to form patterns provided in a plurality of layers, based on data that has undergone OPC, and at least one mask (or photomask) for forming patterns of each layer may be fabricated. In one or more example embodiments, the layout of an IC may be limitedly modified in operation S70. Limitedly modifying an IC in operation S70 may include post processing for optimizing the structure of the IC and may be referred to as design polishing.

An IC may be manufactured in operation S90. For example, an IC may be manufactured by patterning a plurality of layers by using at least one mask, which is fabricated in operation S70. For example, front-end-of-line (FEOL) may include planarizing and cleaning a wafer, forming a trench, forming a well, forming a gate electrode, and forming a source and a drain. Individual devices, e.g., transistors, capacitors, resistors, etc., may be provided in a substrate via the FEOL. Back-end-of-line (BEOL) may include silicidation of a gate and source and drain regions, adding a dielectric, planarization, forming a hole, adding a metal layer, forming a via, and forming a passivation layer. The individual devices, e.g., transistors, capacitors, resistors, etc., may be interconnected with each other via the BEOL. In one or more example embodiments, middle-of-line (MOL) may be performed between FEOL and BEOL such that contacts may be provided on individual devices. Thereafter, the IC may be packaged in a semiconductor package and used as a component of various applications.

FIG. 13 is a flowchart of a method of designing an IC, according to one or more example embodiments. For example, the flowchart of FIG. 13 illustrates an example of operation S30 in FIG. 12. As described above with reference to FIG. 12, cells may be placed in operation S30'. As shown in FIG. 13, operation S30' may include a plurality of operations S31, S32, S33, S34 and S35.

Referring to FIG. 13, netlist data may be obtained in operation S31. For example, as described above with reference to FIG. 12, netlist data may be generated as a result of logic synthesis. The netlist data may define standard cells included in an IC and the connections between the standard cells. Herein, the netlist data may be referred to as input data.

An HP region may be defined in operation S32. For example, the semiconductor design tool may identify HP cells defined in the netlist data and define an HP region based on the identified HP cells. Accordingly, the length of the HP region in the X-axis direction, the length of the HP region in the Y-axis direction, and the location of the HP region may be determined.

An interface region may be defined in operation S33. For example, the semiconductor design tool may define an interface region, which surrounds the HP region defined in operation S32. An HD region may be defined as a region surrounding the interface region. As described above according to one or more example embodiments with reference to the drawings, the interface region may have a reduced area, and thus, an IC may have optimal performance and efficiency.

The standard cells may be placed in operation S34. For example, the semiconductor design tool may place HP cells in the HP region defined in operation S32 and place HD cells outside the interface region defined in operation S33. In one or more example embodiments, the pitch of gate electrodes in the HD cells may be the same as that of gate electrodes in the HP cells.

The interface region may be configured in operation S35. For example, the semiconductor design tool may configure the interface region defined in operation S33. In one or more example embodiments, the semiconductor design tool may add gate electrodes extending in the interface region. The pitch of the gate electrodes extending in the interface region may be the same as the pitch of gate electrodes extending in the HD region and the pitch of gate electrodes extending in the HP region. In one or more example embodiments, the semiconductor design tool may add active regions terminating in the interface region. In one or more example embodiments, the semiconductor design tool may add active regions respectively having different lengths in the interface region. In one or more example embodiments, the semiconductor design tool may add wells terminating in the interface region. In one or more example embodiments, the semiconductor design tool may add a well, which connects a well extending from the HD region to a well extending from the HP region. In one or more example embodiments, the semiconductor design tool may add power lines terminating in the interface region. In one or more example embodiments, the semiconductor design tool may add a pattern of a wiring layer, which connects a power line extending from the HD region to a power line extending from the HP region.

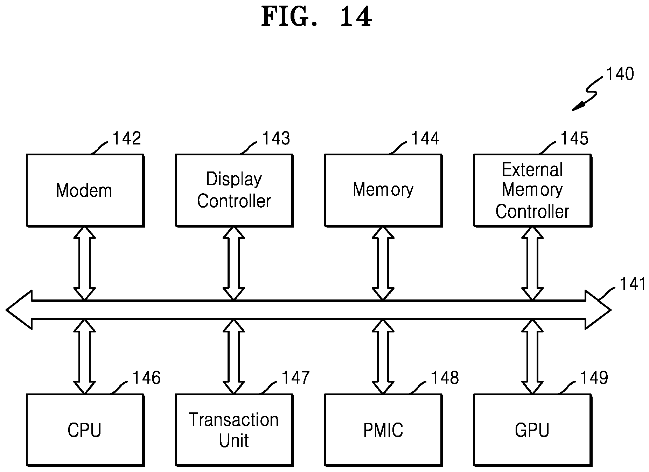

FIG. 14 is a block diagram of a system-on-chip (SoC) 140 according to one or more example embodiments. As a semiconductor device, the SoC 140 may include an IC according to one or more example embodiments. The SoC 140 may be obtained by implementing complex blocks, such as intellectual property (IP), performing various functions in a single chip. The SoC 140 may be designed by a method of designing an IC, according to one or more example embodiments, and may thus have optimal performance and area. Referring to FIG. 14, the SoC 140 may include a modem 142, a display controller 143, a memory 144, an external memory controller 145, a central processing unit (CPU) 146, a transaction unit 147, a power management IC (PMIC) 148, and a graphics processing unit (GPU) 149. The functional blocks of the SoC 140 may communicate with one another through a system bus 141.

The CPU 146 may control the operation of the SoC 140 at the top layer. The CPU 146 may control operations of the other functional blocks, i.e., the modem 142, the display controller 143, the memory 144, the external memory controller 145, the transaction unit 147, the PMIC 148, and the GPU 149. The modem 142 may demodulate a signal received from the outside of the SoC 140 or may modulate a signal generated in the SoC 140 and transmit the generated signal to the outside. The external memory controller 145 may control data communication with an external memory device connected to the SoC 140. For example, a program and/or data may be provided from an external memory device to the CPU 146 or the GPU 149 under control by the external memory controller 145. The GPU 149 may execute program instructions related to graphics processing. The GPU 149 may receive graphics data through the external memory controller 145 and may transmit graphics data, which has been processed by the GPU 149, to the outside of the SoC 140 through the external memory controller 145. The transaction unit 147 may monitor a data transaction of each functional block. Under control by the transaction unit 147, the PMIC 148 may control power supplied to each functional block. The display controller 143 may control a display (or a display device) outside the SoC 140 such that data generated in the SoC 140 may be transmitted to the display. The memory 144 may include non-volatile memory, such as electrically erasable programmable read-only memory (EEPROM) or flash memory, or volatile memory, such as dynamic random access memory (DRAM) or static RAM (SRAM).

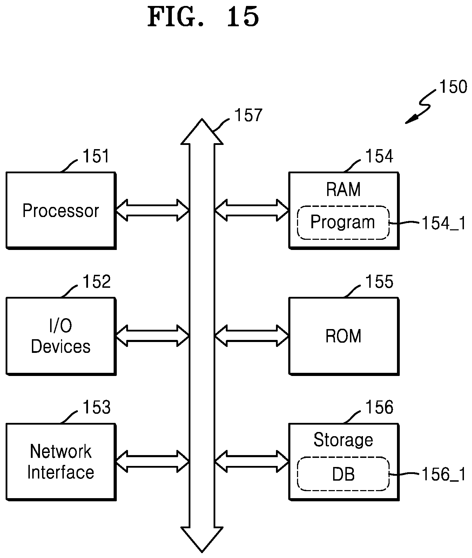

FIG. 15 is a block diagram of a computing system 150 including memory storing a program, according to one or more example embodiments. A method of designing an IC, e.g., at least some of the operations in the flowcharts described above, according to one or more example embodiments may be performed by the computing system (or a computer) 150.

The computing system 150 may include a stationary computing system, such as a desktop computer, a workstation, or a server, or a mobile computing system, such as a laptop computer. As shown in FIG. 15, the computing system 150 may include a processor 151, input/output (I/O) devices 152, a network interface 153, RAM 154, ROM 155, and a storage 156. The processor 151, the I/O devices 152, the network interface 153, the RAM 154, the ROM 155, and the storage 156 may be connected to a bus 157 and communicate with one another through the bus 157.

The processor 151 may be referred to as a processing unit and may include at least one core, such as a microprocessor, an application processor (AP), a digital signal processor (DSP), or a GPU, which may execute an instruction set (e.g., Intel Architecture (IA)-32, 64-bit extension IA-32, x86-64, PowerPC, Sparc, MIPS, ARM, or IA-64). For example, the processor 151 may access memory, i.e., the RAM 154 or the ROM 155, through the bus 157 and may execute instructions stored in the RAM 154 or the ROM 155.

The RAM 154 may store a program 154_1 for executing a method of designing an IC, according to one or more example embodiments, or at least part of the program 154_1. The program 154_1 may enable the processor 151 to perform at least some of the operations included in the method of designing an IC, e.g., the method of FIG. 12. In other words, the program 154_1 may include a plurality of instructions executable by the processor 151, and the instructions included in the program 154_1 may enable the processor 151 to perform at least some of the operations included in the flowcharts described above.

The storage 156 may not lose data stored therein even when power supplied to the computing system 150 is cut off. For example, the storage 156 may include a non-volatile memory device or a storage medium, such as magnetic tape, an optical disk, or a magnetic disk. The storage 156 may be detachable from the computing system 150. The storage 156 may store the program 154_1, according to one or more example embodiments. Before the program 154_1 is executed by the processor 151, the program 154_1 or at least part of the program 154_1 may be loaded from the storage 156 to the RAM 154. Alternatively, the storage 156 may store a file written in a programming language. The program 154_1, which is generated from the file by a compiler or the like, or at least part of the program 154_1 may be loaded to the RAM 154. As shown in FIG. 15, the storage 156 may store a database (DB) 156_1. The DB 156_1 may include information necessary to design an IC, e.g., information about designed blocks, the cell library D12 in FIG. 12, and/or the design rules D14 in FIG. 12.

The storage 156 may store data to be processed by the processor 151 or data that has been processed by the processor 151. In other words, the processor 151 may generate data by processing data stored in the storage 156, according to the program 154_1, and store the generated data in the storage 156. For example, the storage 156 may store the RTL data D11, the netlist data D13, and/or the layout data D15 in FIG. 12.

The I/O devices 152 may include an input device, such as a keyboard or a pointing device, and an output device, such as a display device or a printer. For example, through the I/O devices 152, a user may trigger execution of the program 154_1 by the processor 151, input the RTL data D11 and/or the netlist data D13 in FIG. 12, and check the layout data D15 in FIG. 12.

The network interface 153 may provide access to a network outside the computing system 150. For example, the network may include a plurality of computing systems and communication links. The communication links may include wired links, optical links, wireless links, or other types of links.

While example embodiments have been particularly shown and described above, it will be apparent to those skilled in the art that various changes in form and details may be made therein without departing from the spirit and scope of the following claims.

## Claims

1. An integrated circuit comprising:
a first region comprising:
a plurality of first cells arranged in first rows extending in a first direction; and
a plurality of first gate electrodes extending in a second direction that crosses the first direction;
a second region comprising:
a plurality of second cells arranged in second rows extending in the first direction; and
a plurality of second gate electrodes extending in the second direction; and
a third region between the first region and the second region, the third region comprising a plurality of third gate electrodes extending in the second direction,
wherein a second height of each of the second rows is greater than a first height of each of the first rows, and
wherein a pitch of the plurality of first gate electrodes, a pitch of the plurality of second gate electrodes, and a pitch of the plurality of third gate electrodes are the same.

2. The integrated circuit of claim 1, further comprising:
a plurality of first active patterns extending in the first direction across a boundary between the first region and the second region and terminating in the third region; and
a plurality of second active patterns extending in the first direction across a boundary between the second region and the third region and terminating in the third region.

3. The integrated circuit of claim 2, wherein the plurality of first active patterns comprise at least two first active patterns having different lengths in the first direction in the third region.

4. The integrated circuit of claim 3, wherein the plurality of third gate electrodes comprise at least one third gate electrode crossing the at least two first active patterns.

5. The integrated circuit of claim 2, wherein the plurality of second active patterns comprise at least two second active patterns having different lengths in the first direction in the third region.

6. The integrated circuit of claim 5, wherein the plurality of third gate electrodes comprise at least one third gate electrode crossing the at least two second active patterns.

7. The integrated circuit of claim 1, further comprising:
at least one first well extending in the first direction across a boundary between the first region and the third region and terminating in the third region; and
at least one second well extending in the first direction across a boundary between the second region and the third region and terminating in the third region.

8. The integrated circuit of claim 1, further comprising:
at least one first well extending in the first direction across a boundary between the first region and the second region;
at least one second well extending in the first direction across a boundary between the second region and the third region; and
a third well extending in the second direction in the third region and connected to the at least one first well and to the at least one second well.

9. The integrated circuit of claim 1, further comprising:
a plurality of first power lines configured to provide power to the plurality of first cells, each of the plurality of first power lines extending in the first direction along a boundary of the first rows in the first region and terminating in the third region; and
a plurality of second power lines configured to provide power to the plurality of second cells, each of the plurality of second power lines extending in the first direction along a boundary of the second rows in the second region and terminating in the third region.

10. The integrated circuit of claim 9, wherein each of the plurality of first power lines has a first width,
wherein the plurality of second power lines comprise:
two second power lines extending in the first direction along a boundary between the second region and the third region; and
at least two second power lines having a second width and extending in the first direction between the two second power lines, and
wherein each of the at least two second power lines has a third width that is greater than the first width and that is less than the second width.

11. The integrated circuit of claim 1, wherein the plurality of third gate electrodes comprise at least one third gate electrode terminating in the third region,
wherein the integrated circuit further comprises a wide gate electrode separated in the third region from the at least one third gate electrode in the second direction, and
wherein the wide gate electrode extends in the second direction and has a width that is greater than the pitch of the plurality of third gate electrodes.

12. The integrated circuit of claim 11, further comprising:
a plurality of first active patterns extending in the first direction across a boundary between the first region and the third region and terminating in the third region; and
a plurality of second active patterns extending in the first direction across a boundary between the second region and the third region and terminating in the third region,
wherein the wide gate electrode extends in the second direction between the plurality of first active patterns and the plurality of second active patterns.

13. The integrated circuit of claim 12, wherein each of the plurality of first active patterns has a same length in the first direction in the third region, and
wherein each of the plurality of second active patterns has a same length in the first direction in the third region.

14. The integrated circuit of claim 1, wherein the third region surrounds the second region, and
wherein the first region surrounds the third region.

15. The integrated circuit of claim 14, wherein the second region has a length in the second direction that corresponds to a multiple of a least common multiple of the first height and the second height.
